# EUROPÄISCHE PATENTSCHRIFT

(11) **EP 0 710 972 B1**
(45) Veröffentlichungstag und Bekanntmachung des Hinweises auf die Patenterteilung: **25.02.1998**
(21) Anmeldenummer: 95115649.6
(22) Anmeldetag: 04.10.1995
(51) Int. Cl.: H01H 59/00

(54) **Mikromechanisches Relais**
Micromechanical relay
Relais micromécanique

(30) Priorität: 18.10.1994 DE 4437260
(43) Veröffentlichungstag der Anmeldung: 08.05.1996
(73) Patentinhaber: SIEMENS AKTIENGESELLSCHAFT, 80333 München (DE)
(72) Erfinder: Schlaak, Helmut, Dr., D-13503 Berlin (DE); Schimkat, Joachim, D-13351 Berlin (DE)

(56) Entgegenhaltungen:
- DE-C- 4 205 029

## Beschreibung

Die Erfindung betrifft ein mikromechanisches elektrostatisches Relais mit einem Basissubstrat, das eine Basis-Elektrodenschicht und ein Basis-Kontaktstück tragt, und mit einem auf dem Basissubstrat liegenden Ankersubstrat mit einer freigearbeiteten, einseitig angebundenen Anker-Federzunge, welche eine Anker-Elektrodenschicht und in der Nähe ihres freien Endes ein Anker-Kontaktstück trägt,
wobei die Federzunge mindestens eine Schicht trägt, die gegenüber ihrem Substratmaterial eine mechanische Spannung derart erzeugt, daß die Federzunge im Ruhezustand durch eine stetige Krümmung vom Basissubstrat weg gebogen ist und durch Anlegen einer Steuerspannung zwischen den Elektrodenschichten im Arbeitszustand sich an das Basissubstrat anschmiegt, wobei die beiden Kontaktstücke aufeinanderliegen.

Ein derartiges mikromechanisches Relais ist bereits aus der DE 42 05 029 C1 bekannt. Wie dort ausgeführt ist, läßt sich ein solcher Relaisaufbau beispielsweise aus einem kristallinen Halbleitersubstrat, vorzugsweise Silizium, herstellen, wobei die als Anker dienende Federzunge durch entsprechende Dotierungs- und Ätzvorgänge aus dem Halbleitersubstrat herausgearbeitet wird. Durch Anlegen einer Steuerspannung zwischen der Ankerelektrode der Federzunge und der ebenen Basiselektrode rollt die gekrümmte Federzunge auf der Gegenelektrode ab und bildet damit einen sogenannten Wanderkeil. Während dieses Abrollens wird die Federzunge gestreckt, bis das freie Federende mit dem Ankerkontaktstück das Basiskontaktstück auf dem Basissubstrat berührt.

In der oben genannten Druckschrift ist in allgemeiner Form auch bereits erwähnt, daß durch bestimmte zusätzliche Schichten, wie SiO₂ und Si₃N₄, Verspannungen in der Federzunge erzeugt werden können, durch die die gewünschte Krümmung im Ruhezustand erreicht wird. Vorzugsweise geschieht dies dadurch, daß man auf der der Basiselektrode zugewandten Seite der Federzunge eine Schicht aufbringt, die eine Druckspannung gegenüber dem Substratmaterial der Federzunge erzeugt, wodurch diese sich von dem Basissubstrat weg homogen krümmt.

Die erwähnte Beschichtung mit einem spannungserzeugenden Material hat allerdings zur Folge, daß die Spannungskräfte nicht nur in einer Richtung, sondern nach allen Seiten wirksam werden, so daß die Federzunge nicht nur die erwünschte Krümmung in der Längsrichtung, sondern auch eine meist unerwünschte Wölbung in der Querrichtung erhält. Das bedeutet, daß bei einer Federzunge, die im Mittelbereich ihres freien Endes das Kontaktstück trägt, sich die zu beiden Seiten des Kontaktstücks befindlichen Lappen der Federzunge weiter vom Basissubstrat weg nach oben wölben als der Kontaktbereich. Ohne Vergrößerung des Kontaktabstandes wird also in diesem Bereich der Arbeitsluftspalt zwischen den Elektroden vergrößert, wodurch sich auch die Ansprechspannung in unerwünschter Weise erhöht.

Ziel der vorliegenden Erfindung ist es deshalb, die Federzunge eines Relais der eingangs genannten Art so zu gestalten, daß unerwünschte Querwölbungen vermieden werden können und daß generell Krümmungsbereiche abschnittsweise so eingestellt werden, daß eine optimale Schaltcharakteristik entsteht.

Erfindungsgemäß wird dieses Ziel dadurch erreicht, daß die die mechanische Spannung erzeugende Schicht auf der Federzunge jeweils durch parallele, quer zu einer unerwünschten Krümmungsrichtung verlaufende Schlitze in Streifen unterteilt ist.

Für eine bevorzugte Ausführungsform, bei der die Federzunge auf der dem Basissubstrat zugewandten Seite eine eine Druckspannung erzeugende Schicht, z. B. SiO₂ aufweist, bedeutet dies, daß in Längsrichtung der Federzunge verlaufende Schlitze vorgesehen werden, um die Längskrümmung der Federzunge zu erreichen und eine Querwölbung zu vermeiden. Dabei kann es zusätzlich von Vorteil sein, daß die Federzunge auf der dem Basissubstrat zugewandten Seite eine zusätzliche, eine Zugspannung erzeugende Schicht, vorzugsweise Si₃N₄, trägt, deren Dicke wesentlich geringer als die der Druckspannungsschicht ist und die auch die Schlitze ohne Unterbrechung überzieht.

Unter Umständen ist es auch erwünscht, daß die Krümmung der Federzunge nur über einen bestimmten Bereich erhalten wird, andere Bereiche dagegen, wie etwa der das Kontaktstück tragende Abschnitt, möglichst eben sind. Für diesen Fall ist in einer Weiterbildung der Erfindung vorgesehen, daß die die mechanische Spannung erzeugende Schicht durch ein Gitter von zueinander senkrechten Schlitzen schachbrettähnlich unterteilt ist. Durch eine besonders dichte Anordnung von Schlitzen quer zur Längsrichtung der Federzunge kann dabei mit Hilfe der erwähnten zweiten, eine Zugspannung erzeugenden Schicht auch eine Krümmung entgegengesetzt zur Hauptkrümmungsrichtung der Federzunge erzeugt werden.

Die Erfindung wird nachfolgend an Ausführungsbeispielen anhand der Zeichnung näher erläutert. Es zeigt
Figur 1 eine schematische Darstellung für den grundsätzlichen Aufbau eines mikromechanischen Relais mit einer gekrümmten Anker-Federzunge im Schnitt,
Figur 2 eine Ansicht von unten auf eine Federzunge mit einem in bekannter Weise durch Schlitze abgegrenzten Kontaktfederabschnitt,
Figur 3 eine schematische Darstellung der Spannungszustände in einem Schichtsystem einer Federzunge,
Figur 4 eine Draufsicht auf eine Federzunge gemäß Figur 2 mit eingezeichneten Höhenlinien zur Darstellung der bei gleichmäßiger Beschichtung erzeugten Wölbung im Ruhezustand,
Figur 5 einen Federzungenabschnitt im Querschnitt zur Darstellung einzelner Schlitze im Schichtsystem,
Figur 6 eine Federzunge in Draufsicht mit einer schematisch dargestellten Schlitzstruktur,
Figur 7a und 7b die Federzunge von Figur 6 in Seitenansicht im Ruhezustand und im Arbeitszustand,
Figur 8 ein weiteres Beispiel einer Federzunge mit einer abgewandelten Schlitzstruktur in Draufsicht und in schematisierter Seitenansicht,
Figur 9 und 10 zwei Ausführungsbeispiele für die Gestaltung der Schlitzstruktur in Querschnittsdarstellung.

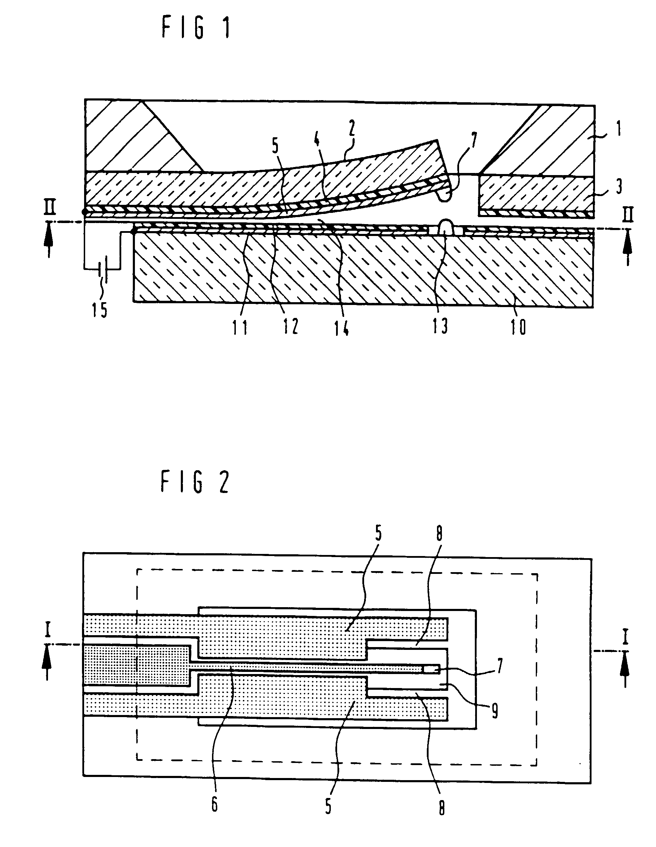

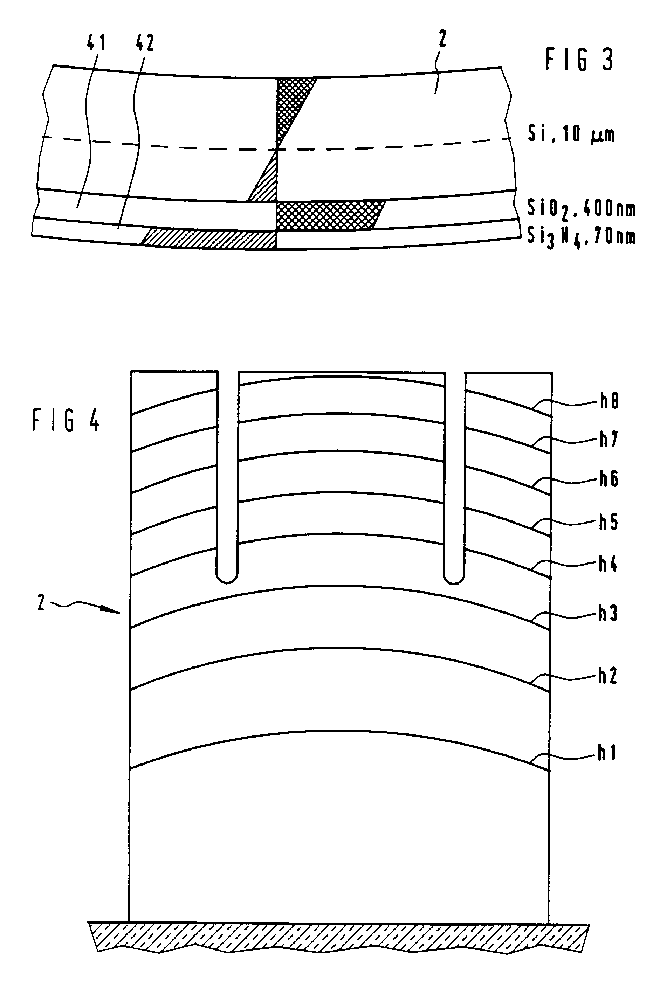

Figur 1 zeigt schematisch den grundsätzlichen Aufbau eines mikromechanischen elektrostatischen Relais, bei dem die Erfindung zur Anwendung kommt. Dabei ist an einem Ankersubstrat 1, vorzugsweise einem Silizium-Wafer, eine Anker-Federzunge 2 innerhalb einer entsprechend dotierten Silizium-Schicht durch selektive Ätzverfahren freigearbeitet. An der Unterseite der Federzunge ist eine Doppelschicht 4 erzeugt, die in dem Beispiel aus einer Si0₂-Schicht, welche Druckspannungen erzeugt, und einer Si₃N₄-Schicht, welche Zugspannungen erzeugt, besteht; anhand von Figur 3 wird darauf noch näher eingegangen. Durch entsprechende Wahl der Schichtdicken kann der Federzunge eine gewünschte Krümmung verliehen werden. Schließlich trägt die Federzunge eine metallische Schicht als Ankerelektrode 5 an ihrer Unterseite. Diese Ankerelektrode 5 ist, wie in Figur 2 zu sehen, zweigeteilt, um in der Mitte der Federzunge eine metallische Zuleitung 6 für ein Anker-Kontaktstück 7 zu bilden.

Wie aus Figur 2 weiter ersichtlich ist, ist am freien Ende der Federzunge durch zwei Schlitze 8 ein Kontaktfederbereich 9 freigeschnitten, der das Kontaktstück 7 trägt. Dieser Kontaktfederbereich 9 kann sich beim flachen Aufliegen der Ankerelektrode 5 auf einer Basiselektrode elastisch durchbiegen, wodurch die Kontaktkraft erzeugt wird.

Wie in Figur 1 weiter zu sehen ist, ist das Ankersubstrat 1 auf einem Basissubstrat 10 befestigt, welches im vorliegenden Beispiel aus Pyrex-Glas besteht, das aber beispielsweise auch aus Silizium gebildet sein könnte. Auf seiner ebenen Oberfläche trägt das Basissubstrat 10 eine Basiselektrode 11 und eine Isolierschicht 12, um die Basiselektrode 11 gegenüber der Ankerelektrode 5 zu isolieren. Ein Basis-Kontaktstück 13 ist in nicht weiter dargestellter Weise mit einer Zuleitung versehen und natürlich gegenüber der Basiselektrode 11 isoliert angeordnet. Zwischen der gekrümmten Federzunge 2 mit der Ankerelektrode 5 einerseits und der Basiselektrode 11 andererseits ist ein keilförmiger Luftspalt 14 ausgebildet. Bei Anliegen einer Spannung von einer Spannungsquelle 15 zwischen den beiden Elektroden 5 und 11 rollt die Federzunge auf der Basiselektrode 11 ab, wodurch das Ankerkontaktstück 7 mit dem Basiskontaktstück 13 verbunden wird. Die Größenverhältnisse und Schichtdicken sind lediglich unter dem Gesichtspunkt der Anschaulichkeit gewählt und entsprechen nicht den tatsächlichen Verhältnissen.

Eine mikromechanisch hergestellte Federzunge gemäß Figur 1, die ohne Erregung im Ruhezustand eine Krümmung aufweist, muß durch ein geeignetes Schichtsystem vorgespannt sein. Dies läßt sich dadurch erreichen, daß die der Basiselektrode zugewandte Seite eine Druckspannung gegenüber der Zungenrückseite aufweist. Deformationen von Si-Zungen lassen sich erzeugen, indem ein vorgespanntes Schichtsystem auf der Si-Wafer-Oberfläche aufgebracht wird. Derartige Vorspannungen entstehen durch das Einfrieren thermischer Ausdehnungen beim Herstellprozeß. Eine Si0₂-Schicht wird z. B. durch thermische Oxydation von Silizium bei etwa 1100° C erzeugt. Si0₂ hat einen geringeren Ausdehnungskoeffizienten als Si, so daß beim Abkühlen die Si0₂-Schicht gegenüber dem Si-Substrat unter Druckspannung steht und im Fall einer freigeätzten Zunge eine homogen gekrümmte Durchbiegung in das Ankersubstrat hinein bewirkt. Si₃N₄-Schichten erzeugen andererseits gegenüber dem Si-Substrat Zugspannungen, da ihr Ausdehnungskoeffizient größer als der von Si ist. Durch Kombination einer Si0₂- und einer Si₃N₄-Schicht kann die Krümmung allein durch Wahl der beiden Schichtdicken beliebig eingestellt werden.

In Figur 3 ist ein solches Schichtsystem beispielshalber dargestellt. Dabei ist auf einer Silizium-Zunge mit einer Dicke von etwa 10 µm eine Si₂-Schicht von etwa 400 nm und auf dieser wiederum eine Si₃N₄-Schicht von etwa 70 nm aufgebracht. Die Schichtdicken lassen sich bei der Herstellung auf 1 bis 2 % genau einhalten. Computer-Simulationen mit FEM (Finite-Elemente-Methode) ergaben eine Abweichung der Öffnung von ca. 0,1 µm, das entspricht einem Fehler von ca. 1 %. Somit ist ein solches Schichtsystem auch großtechnisch beherrschbar. In Figur 3 ist die in der Si0₂-Schicht herrschende Druckspannung durch eine Kreuzschraffur angedeutet, während die in der Si₃N₄-Schicht herrschende Zugspannung durch eine einfache Schraffur angedeutet ist. Da die Si0₂-Schicht wesentlich dicker ist als die Si₃N₄-Schicht, ergibt sich insgesamt eine Biegung der Zunge nach oben, wobei innerhalb der Si-Zunge wiederum Bereiche mit Zugspannungen und Druckspannungen beiderseits einer neutralen Zone auftreten.

Bei einer Federzunge gemäß Figur 1 bewirkt nun eine solche Schichtstruktur mit durchgehenden Schichten eine Durchwölbung um zwei Achsen, was in Figur 4 gezeigt ist. Hier ist die Federzunge 2 in Draufsicht dargestellt, wobei die Wölbung nach oben von der Grundebene des Ankersubstrats durch einzelne Höhenlinien hl bis h8 deutlich gemacht ist. Jede Höhenlinie entspricht einem bestimmten Durchbiegungswert bzw. Abstand von der Grundfläche. Bei einer Federzunge von 1300 µm Länge und 1000 µm Breite mit der oben erwähnten Schichtstruktur ergab die Simulation beispielsweise für die Höhenlinie hl einen Abstand von 1,2 µm und bei der Höhenlinie h8 einen Abstand von 9,3 µm gegenüber der Grundfläche, so daß am Federende ein Abstand von annähernd 11 µm zustandekommt. Die Höhenlinien verlaufen auch nicht gerade, sondern sie sind gekrümmt, was bedeutet, daß die Federzunge nicht nur in ihrer Längsrichtung gekrümmt ist, sondern auch in der Querrichtung eine Wölbung aufweist. Dies hat die eingangs bereits erwähnten Nachteile, weshalb mit der Erfindung angestrebt wird, die besagten Querwölbungen zu vermeiden.

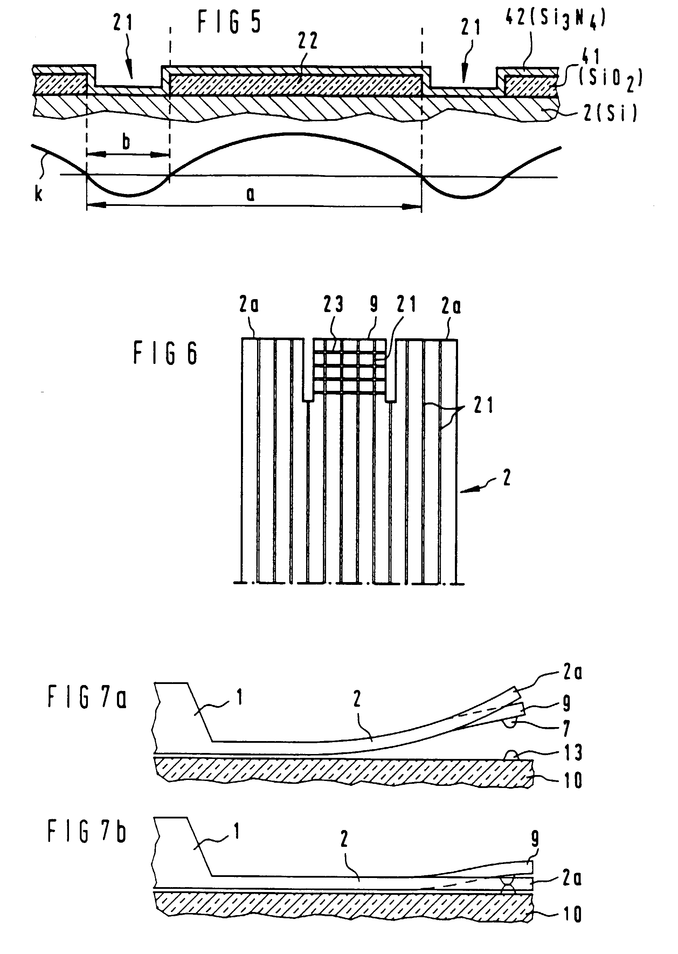

Figur 5 zeigt schematisch einen Querschnitt durch die Federzunge mit dem Schichtaufbau gemäß Figur 3. Dabei sind jedoch im Abstand a jeweils Längsschlitze 21 der Breite b eingebracht, während die Si₃N₄-Schicht durchgehend auch über die Schlitze hinweg verläuft. Die Schlitzbreite kann beispielsweise 2 um betragen. In Figur 5 ist außerdem unterhalb der Zunge der Krümmungsverlauf k angedeutet. Man erkennt, daß die einwärts gerichtete Wölbung aufgrund der Druckspannung der Si0₂-Schicht nunmehr auf die Breite der Streifen 22 zwischen den Schlitzen 21 beschränkt ist, wobei in den Schlitzen aufgrund der Zugspannung der Si₃N₄-Schicht eine entgegengesetzte Wölbung der Zunge bewirkt wird. Insgesamt erhält die Zunge also in Querrichtung einen etwas welligen, insgesamt jedoch geraden Verlauf. Durch entsprechende Wahl der Anzahl der Schlitze 21 bzw. der Breite der Streifen 22 kann die Kompensation der Querwölbung in gewünschter Weise eingestellt werden.

Figur 6 zeigt in Draufsicht schematisch eine Federzunge mit Längsschlitzen 21 gemäß Figur 5. Dabei sind die Längsschlitze über die gesamte Länge der Federzunge 2 geführt, einschließlich der Seitenlappen 2a am freien Ende. Für den Kontaktfederbereich 9 zwischen den beiden Seitenlappen 2a ist jedoch zur besseren Ausrichtung des Kontaktstückes erwünscht, daß dieser Bereich eben ist; da er keine Elektrodenfläche trägt, steuert er auch nichts zur elektrostatischen Anziehung bei. Deshalb ist dieser Bereich 9 zusätzlich zu den Längsschlitzen 21 auch mit Querschlitzen 23 versehen, wodurch bei entsprechender Dimensionierung ein praktisch ebener Kontaktfederbereich erzeugt wird. Die Figuren 7a und 7b zeigen eine solche Federzunge gemäß Figur 6 in Seitenansicht, und zwar im unerregten Ruhezustand (Figur 7a) und im angezogenen Zustand (Figur 7b).

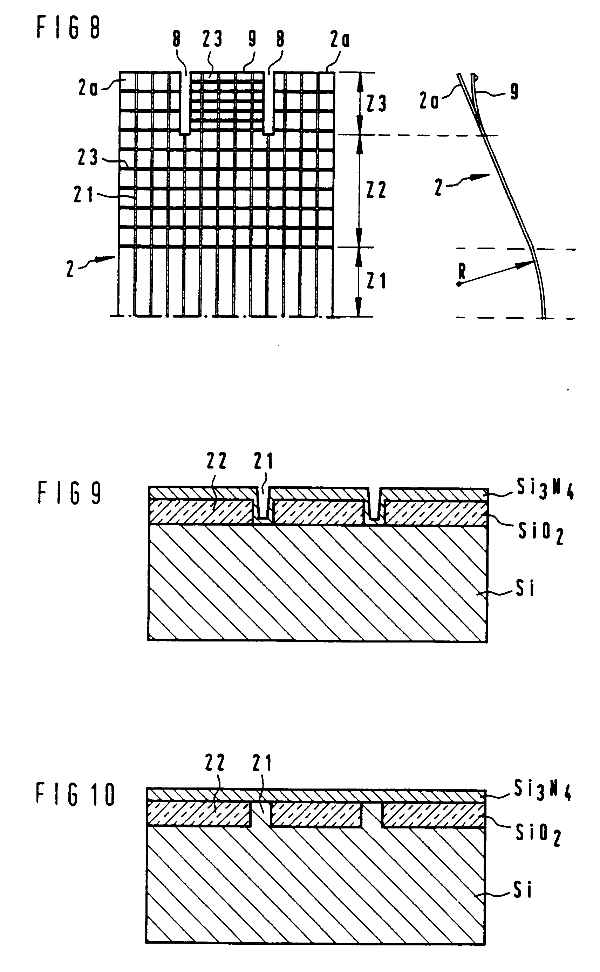

Für eine optimale Schaltcharakteristik bezüglich der Kippzustände beim Schließen und Öffnen des Relais, also beispielsweise zur Vermeidung des Kontaktschleichens, ist eine Schaltzunge erwünscht, die nur über einen Teil ihrer Länge eine Krümmung aufweist und im übrigen Bereich eben ist. Da die Schichtabscheidung über den gesamten Silizium-Wafer homogen erfolgt, sind abschnittsweise variierende Schichtdicken schwer herstellbar. Durch die erfindungsgemäße Maßnahme läßt sich nun eine Variation der Krümmung über verschiedene Bereiche erzeugen. So zeigt Figur 8 eine Federzunge 2 in Draufsicht und in schematisierter Seitenansicht, wobei drei verschiedene Abschnitte unterschiedlich geschlitzt sind und dementsprechend auch unterschiedliche Krümmungen aufweisen. Ein erster Bereich Z1 im Anschluß an die Einspannung der Federzunge 2 trägt Schlitze 21 nur in Längsrichtung; dementsprechend ist dieser Bereich in Längsrichtung mit dem Radius R gekrümmt. Der Bereich Z2 trägt Längsschlitze 21 und Querschlitze 23, wodurch dieser Bereich der Federzunge im wesentlichen eben gehalten ist. Der Endbereich Z3 schließlich ist durch die Federzungenschlitze 8 in die Seitenlappen 2a und in den Kontaktfederbereich 9 unterteilt. Die Seitenlappen 2a tragen Längs- und Querschlitze wie der Bereich Z2. Der Kontaktfederbereich 9 trägt ebenfalls Längsschlitze 21 und Querschlitze 23. In diesem Fall sind jedoch die Querschlitze 23 so eng angeordnet, daß sich eine Krümmung dieses Abschnittes entgegengesetzt zum Bereich Z1 ergibt; das bedeutet, daß der Kontaktfederabschnitt zum Basiskontaktstück hin gekrümmt ist.

Die fertigungstechnische Erzeugung der Schlitze in der Druckspannungsschicht kann gemäß Figur 9 dadurch erfolgen, daß aus einer ganzflächigen Si0₂-Schicht mit Hilfe eines Lithographieschrittes die Schlitzstrukturen herausgeätzt werden und anschließend die Si₃N₄-Schicht wiederum ganzflächig, z. B. durch Gasphasenabscheidung, aufgebracht wird.

Eine andere Möglichkeit zeigt Figur 10. Hier wird die Oxydation örtlich bereits begrenzt, indem zuvor eine entsprechende Markierungsschicht (z. B. Si₃N₄) aufgebracht wird, so daß die Si0₂-Schicht bereits in Streifenform entsteht. Danach wird wiederum die Si₃N₄-Schicht über die ganze Fläche aufgebracht. Es kann auch statt der Si0₂-Schicht eine Dotierung des Siliziums erfolgen, die Druckspannungen erzeugt. Danach wird wiederum die Si₃N₄-Schicht ganzflächig abgeschieden. Der Vorteil dieses Verfahrens besteht in der glatten Oberflächentopographie.

## Patentansprüche

1. Mikromechanisches elektrostatisches Relais mit einem Basissubstrat (10), das eine Basis-Elektrodenschicht (11) und ein Basis-Kontaktstück (13) trägt, und mit einem auf dem Basissubstrat (10) liegenden Ankersubstrat (1) mit einer freigearbeiteten, einseitig angebundenen Anker-Federzunge (2), welche eine Anker-Elektrodenschicht (5) und in der Nähe ihres freien Endes ein Anker-Kontaktstück (7) trägt,
wobei die Federzunge (2) mindestens eine Schicht (4) trägt, die gegenüber ihrem Substratmaterial eine mechanische Spannung derart erzeugt, daß die Federzunge (2) im Ruhezustand durch eine stetige Krümmung vom Basissubstrat (10) weg gebogen ist und durch Anlegen einer Steuerspannung zwischen den Elektrodenschichten (5, 11) im Arbeitszustand sich an das Basissubstrat (10) anschmiegt, wobei die beiden Kontaktstücke (7, 13) aufeinanderliegen, **dadurch gekennzeichnet**, daß die die mechanische Spannung erzeugende Schicht (4; 41) auf der Federzunge jeweils durch parallele, quer zu einer unerwünschten Krümmungsrichtung verlaufende Schlitze (21; 23) in Streifen (22) unterteilt ist.

2. Relais nach Anspruch 1, **dadurch gekennzeichnet,** daß die Federzunge (2) auf der dem Basissubstrat (10) zugewandten Seite eine eine Druckspannung erzeugende Schicht (41), vorzugsweise Si0₂, aufweist, welche durch Schlitze (21) in Längsrichtung der Federzunge in Streifen (22) unterteilt ist.

3. Relais nach Anspruch 2, **dadurch gekennzeichnet,** daß die Federzunge (2) auf der dem Basissubstrat (10) zugewandten Seite eine zusätzliche, eine Zugspannung erzeugende Schicht (42), vorzugsweise Si₃N₄, trägt, deren Dicke wesentlich geringer als die der Druckspannungsschicht (41) ist und die auch die Schlitze (21) ohne Unterbrechung überzieht.

4. Relais nach einem der Ansprüche 1 bis 3, **dadurch gekennzeichnet,** daß zur Erzielung von ebenen Bereichen (Z2, 9) die die mechanische Spannung erzeugende Schicht (41) durch ein Gitter von zueinander senkrechten Schlitzen (21, 23) schachbrettähnlich unterteilt ist.

5. Relais nach Anspruch 3 oder 4, **dadurch gekennzeichnet,** daß durch eine dichte Anordnung von Schlitzen quer zur Längsrichtung der Federzunge (2) ein entgegengesetzt zur Hauptkrümmungsrichtung gekrümmter Bereich (9) erzeugt ist.

6. Relais nach einem der Ansprüche 1 bis 5, **dadurch gekennzeichnet,** daß die spannungserzeugende Schicht (41) streifenförmig auf das Substrat aufgebracht ist und daß die Schlitze (21) zwischen den Streifen (22) durch Stege des Substrats ausgefüllt sind.

7. Relais nach einem der Ansprüche 1 bis 5, **dadurch gekennzeichnet,** daß in die die spannungserzeugende Schicht (41) unterteilenden Schlitze (21) als Vertiefungen zwischen den verbleibenden Streifen (22) dieser Schicht ausgebildet sind und daß eine eine Gegenspannung erzeugende weitere Schicht (22) sich in die Vertiefungen hinein erstreckt.

## Claims

1. Micromechanical electrostatic relay having a base substrate (10) which is fitted with a base electrode layer (11) and a base contact piece (13), and having an armature substrate (1) which is located on the base substrate (10) and has an armature spring tongue (2) which is machined out, is attached on one side and is fitted with an armature electrode layer (5) and, in the vicinity of its free end, with an armature contact piece (7), the spring tongue (2) having at least one layer (4) which produces a mechanical stress with respect to its substrate material in such a manner that the spring tongue (2) is bent away from the base substrate (10) in the rest state by continuous curvature and, in the operating state when a control voltage is applied between the electrode layers (5, 11), becomes closely adjacent to the base substrate (10), the two contact pieces (7, 13) resting against one another, characterized in that the layer (4; 41) (which produces the mechanical stress) on the spring tongue is in each case divided into strips (22) by parallel slots (21; 23) which run transversely with respect to an undesired curvature direction.

2. Relay according to Claim 1, characterized in that the spring tongue (2) has, on the side facing the base substrate (10), a layer (41), preferably SiO₂, which produces compressive stress and is divided by slots (21) into strips (22) in the longitudinal direction of the spring tongue.

3. Relay according to Claim 2, characterized in that the spring tongue (2) has, on the side facing the base substrate (10), an additional layer (42), preferably Si₃N₄, which produces tensile stress and whose thickness is considerably less than that of the compressive stress layer (41), and which also covers the slots (21) without any interruption.

4. Relay according to one of Claims 1 to 3, characterized in that, in order to achieve planar areas (Z2, 9), the layer (41) which produces the mechanical stress is divided like a chessboard by a grid of mutually perpendicular slots (21, 23).

5. Relay according to Claim 3 or 4, characterized in that an area (9) which is curved in the opposite direction to the main curvature direction is produced by a close arrangement of slots transversely with respect to the longitudinal direction of the spring tongue (2).

6. Relay according to one of Claims 1 to 5, characterized in that the layer (41) which produces the stress is applied to the substrate in the form of strips, and in that the slots (21) between the strips (22) are filled by webs of the substrate.

7. Relay according to one of Claims 1 to 5, characterized in that the slots (21) which divide the stress-producing layer (41) are constructed as depressions between the remaining strips (22) of this layer, and in that a further layer (22), which produces an opposing stress, extends into the depressions.

## Revendications

1. Relais micromécanique électrostatique comportant un substrat de base (10), portant une couche d'électrodes de base (11) et un élément de contact de base (13), et comportant un substrat d'induit (1), placé sur le substrat de base (10), avec une lame de ressort d'induit (2) dégagée et reliée d'un côté qui porte une couche d'électrodes d'induit (5) et un élément de contact d'induit (7) à proximité de son extrémité libre,
la lame de ressort (2) portant au moins une couche (4), qui crée par rapport à sa matière de substrat une tension mécanique telle que la lame de ressort (2) est recourbée à l'état de repos par une courbure continue s'éloignant du substrat de base (10) et, par application d'une tension de commande entre les couches d'électrodes (5, 11), épouse la forme du substrat de base (10) à l'état de fonctionnement, les deux éléments de contact (7, 13) étant situés l'un sur l'autre, caractérisé en ce que la couche créant la tension mécanique (4 ; 41) sur la lame de ressort est divisée en bandes (22) respectivement par des fentes parallèles (21 , 23), s'étendant transversalement à un sens de courbure non souhaité.

2. Relais selon la revendication 1, caractérisé en ce que la lame de ressort (2) présente, sur le côté orienté vers le substrat de base (10), une couche (41), créant une tension de compression, de préférence en SiO2, laquelle est divisée en bandes (22) par des fentes (21) dans le sens longitudinal de la lame de ressort.

3. Relais selon la revendication 2, caractérisé en ce que la lame de ressort (2) porte sur le côté orienté vers le substrat de base (10) une couche supplémentaire (42), qui crée une tension de traction, de préférence en Si3N4, dont l'épaisseur est essentiellement inférieure à celle de la couche de tension de compression (41) et qui recouvre aussi sans interruption les fentes (21).

4. Relais selon l'une des revendications 1 à 3, caractérisé en ce que pour obtenir des zones planes (Z2, 9), la couche créant la tension mécanique (41) est divisée de façon semblable à un échiquier par une grille de fentes perpendiculaires les unes par rapport aux autres (21, 23).

5. Relais selon la revendication 3 ou 4, caractérisé en ce qu'une zone (9) recourbée de façon opposée au sens de courbure principal est réalisée par un agencement dense de fentes transversalement au sens longitudinal de la lame de ressort (2).

6. Relais selon l'une des revendications 1 à 5, caractérisé en ce que la couche créatrice de tension (41) est appliquée sous forme de bandes sur le substrat et en ce que les fentes (21) entre les bandes (22) sont remplies par des entretoises du substrat.

7. Relais selon l'une des revendications 1 à 5, caractérisé en ce que les fentes (21) qui divisent la couche créatrice de tension (41) sont conçues comme des cavités entre les bandes restantes (22) de cette couche et en ce qu'une autre couche (22), qui crée une tension opposée, s'étend dans les cavités.
